**Europäisches Patentamt**

**European Patent Office**

**Office européen des brevets**

(19)

(11) Numéro de publication: **0 128 804**
**B1**

(12) **FASCICULE DE BREVET EUROPEEN** .

(45) Date de publication du fascicule du brevet: **20.07.88**

(51) Int. Cl.⁴: **G 01 S 1/30,** G 01 R 25/00

(21) Numéro de dépôt: **84401084.3**

(22) Date de dépôt: **25.05.84**

(54) **Procédé de traitement de signaux radio-électriques pour la radio-navigation et récepteur pour la mise en oeuvre de ce procédé.**

(30) Priorité: **30.05.83 FR 8308916**
**26.04.84 FR 8406597**

(43) Date de publication de la demande:
**19.12.84 Bulletin 84/51**

(45) Mention de la délivrance du brevet:
**20.07.88 Bulletin 88/29**

(84) Etats contractants désignés:
**BE DE GB IT SE**

(56) Documents cités:
**EP-A-0 079 280**
**US-A-3 936 763**
**US-A-4 138 680**

**L'ONDE ELECTRIQUE, vol. 33, no. 314, mai 1953, Paris (FR) E. HONORE et al.: "Les radionavigateurs RANA", pages 319-327.**
**L'ONDE ELECTRIQUE, vol. 55, no. 6, juin 1975, Paris (FR) J. AZENCOT et al.: "Phasemètre large band à détection synchrone utilisant une ligne à retard comme étalon de temps", pages 341-346.**

(73) Titulaire: **MLR ELECTRONIQUE**
**13 rue François Luneau**
**F-44330 Vallet (FR)**

(72) Inventeur: **Lamiraux, Christian**
**6 rue de l'Allier**
**F-44230 Saint Sebastien sur Loire (FR)**

(74) Mandataire: **Durand, Yves Armand Louis et al**
**Cabinet Z. Weinstein 20, Avenue de Friedland**
**F-75008 Paris (FR)**

(56) References cited:
**WESCON CONFERENCE RECORD, vol. 25, septembre 1981, El Segundo, CA (US) R. TALAMBIRAS: "Sampling network analyzer for periodic functions", pages 1-7.**

Courier Press, Leamington Spa, England.

## Description

La présente invention concerne un procédé de traitement d'une série de signaux notamment radio-électriques présentant un même écart d'une basse fréquence entre signaux adjacents, notamment des signaux de radio-fréquence d'un système de radio-navigation tel que le système RANA, pour permettre par exploitation des phases des signaux reçus, la localisation d'un poste récepteur, et un récepteur pour la mise en oeuvre de ce procédé.

Les procédés classiques consistent à transformer les signaux de radio-fréquence en signaux présentant une fréquence plus basse, à l'aide des moyens mélangeurs, à séparer les différents signaux de fréquence plus basse dans des filtres accordés de façon à obtenir en sortie de chacun des filtres un signal isolé des signaux adjacents. Ces procédés connus ont pour inconvénient majeur que les filtres doivent présenter des caractéristiques de sélectivité aiguës du fait de la proximité des fréquences à séparer. Le déphasage inhérent au filtrage est susceptible d'entraîner des erreurs aléatoires dans les mesures de déphasage qui suivent. Cette technique doit donc être généralement complétée par des mesures dites d'auto-test qui nécessitent d'engendrer localement des signaux étalonnés qu'on substitue momentanément aux signaux de réception. Il est d'autre part à constater que ces procédés connus nécessitent autant de filtres que de signaux à traiter car, comme il est bien connu, il faut au moins trois filtres pour pouvoir établir deux mesures de différence de phase. Il en résulte une structure complexe et onéreuse de récepteurs.

Le brevet US—A—3 936 763 au nom de PALMER concerne un appareil pourvu de filtres suiveur pour déterminer la phase relative des signaux radio-électriques dans des systèmes de radio-navigation tels que des systèmes OMEGA, DECCA et LORAC.

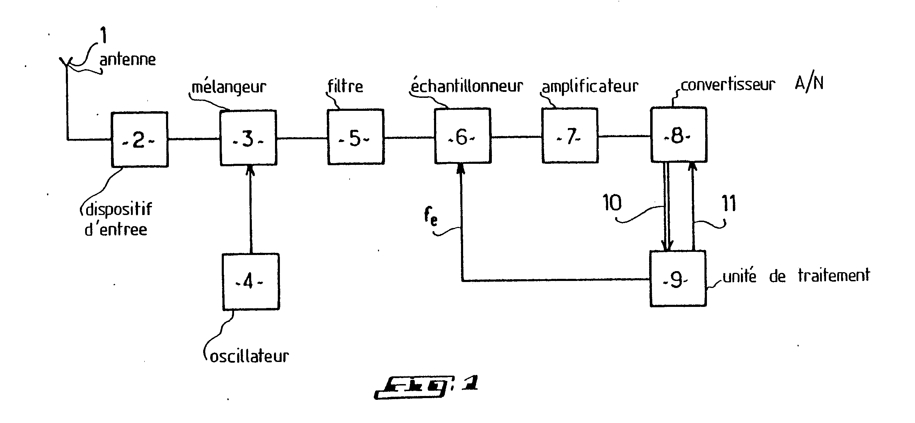

Le dispositif de traitement de signaux, du type OMEGA décrit dans PALMER et représente à la figure 1, comprend une interface d'ordinateur adaptée pour produire des signaux de données pour que l'appreil puisse déterminer les phases des signaux OMEGA à deux fréquences (10,2 kHz et 13,6 kHz). Pour déterminer la phase relative de chacun des deux signaux, l'appareil selon PALMER utilise une boucle de contrôle ou de verrouillage de phases pour chacun de ces deux signaux.

La présente invention a pour but de présenter un procédé et un récepteur qui ne présentent pas les inconvénients susmentionnés, inhérents aux procédés et récepteurs connus.

Pour atteindre ce but, le procédé selon l'invention est caractérisé en ce que l'on transforme les signaux radio-électriques reçus en une première série de signaux de plus basse fréquence dont chacune constitue une harmonique ou un multiple de la fréquence d'écartement entre deux signaux radio-électriques adjacents, qu'on échantillonne le signal composite des signaux de plus basse fréquence et produise localement une deuxième série de signaux de plus basse fréquence, qui comporte les mêmes composantes de fréquence que ledit signal comporte et détermine les valeurs des signaux locaux par corrélation avec les échantillons.

Suivant une caractéristique avantageuse de l'invention, on produit localement la série par une analyse programmée à l'aide d'une unité de traitement telle qu'un ordinateur ou microprocesseur.

Suivant une autre caractéristique avantageuse, on prédétermine par estimation pour chaque signal reçu une phase que l'on vérifie et adapte en tenant compte des valeurs des échantillons en vue d'asservir la phase estimée à la phase du signal reçu correspondant, la phase estimée asservie étant directement exploitable pour la radio-localisation.

Le récepteur pour la mise en oeuvre du procédé selon la présente invention est caractérisé conformément à la revendication 6.

Suivant une autre caractéristique de l'invention, le système logique comprend au moins une unité de traitement telle qu'un ordinateur ou microprocesseur adapté pour assurer la coopération et le fonctionnement synchrone des dispositifs constitutifs du système d'acquisition et de traitement et du système logique.

Selon une autre caractéristique avantageuse de l'invention, le système d'acquisition et de traitement comprend un montage en série de moyens amplificateurs et de moyens mélangeurs, les moyens amplificateurs comprenant un amplificateur haute fréquence accordé sous l'effet d'une tension de commande automatique de fréquence fournie par le système de logique et les moyens mélangeurs étant commandés par des signaux produits par le système logique.

Selon une autre caractéristique avantageuse de l'invention, le récepteur comprend un oscillateur pilote de fréquence nominale qui comporte des moyens tels qu'un potentiomètre permettant un réglage gros pas ajustement de la fréquence centrale et des moyens adaptés pour assurer un réglage fin de la fréquence par signal de commande issu du système logique, le signal pilote de l'oscillateur étant transmis au système logique.

Selon une autre caractéristique avantageuse de l'invention, l'unité de traitement ou de calcul du système logique comprend un compteur diviseur interne de fréquence, adapté pour produire à partir du signal piloté précité un signal de sortie permettant la production par division de fréquence des signaux de référence nécessaires au cadencement des opérations effectuées par le système d'acquisition et de traitement.

Selon encore une autre caractéristique avantageuse de l'invention, l'unité de traitement ou de calcul est reliée par un bus de donnée bidirectionnel à un convertisseur analogique-numérique destiné à transmettre à l'unité de traitement les mesures des phases et d'amplitude des signaux de réception et à un circuit adapté au transfert des données programmées de fréquences de réception et pour la commande des tensions de contrôle automatique de gain destinées aux moyens amplificateurs du système d'acquisition et d'asservissement de l'oscillateur pilote ainsi que pour la réception de signaux d'interruption destinés à cadencer le programme du récepteur.

Selon encore une autre caractéristique, le circuit de transfert et de commande est relié par un bus à un compteur programmable dont il règle le taux de division de fréquence de manière à créer la fréquence nécessaire pour aligner le récepteur subséquemment sur les différentes fréquences du système de radio-navigation.

L'invention sera mieux comprise, et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un seul mode de réalisation de l'invention, et dans lesquels:

La figure 1 montre sous forme d'un schéma-bloc le principe d'un récepteur suivant la présente invention.

La figure 2 donne le schéma-bloc d'un système d'acquisition et de traitement de la présente invention.

La figure 3 illustre sous forme d'un schéma-bloc le système logique d'un récepteur selon l'invention.

La présente invention sera décrite à titre d'exemple dans son application au système de radio-navigation du type RANA.

Un récepteur de signaux du type RANA doit traiter des signaux de phase reçus sur une série de fréquences séquentielles et une autre série de fréquences dites permanentes. Dans le cadre de la présente invention, seules les fréquences permanentes sont traitées. Un réseau RANA peut contenir 18 stations émettrices. Chaque station, désignée par un numéro N égal 1 à 9 ou 11 à 19 émet une fréquence permante F. Deux fréquences adjacentes de la série des signaux émis sont séparées d'une basse fréquence $\Delta f$.

La figure 1 montre sous forme d'un schéma-bloc un récepteur destiné au traitement des signaux selon la présente invention. La série des signaux RANA est captée par l'antenne 1, et parvient, après avoir été traitée dans un dispositif d'entrée 2, à un mélangeur 3 relié à un oscillateur pilote local 4. Ce mélangeur transforme la série de signaux de radio-fréquence reçus en une première série de signaux de plus basse fréquence. Le mélangeur est suivi d'un filtre unique 5 à bande de passage relativement étroite. A la sortie du filtre on retrouve un signal composite formé par superposition des signaux de basse fréquence obtenus par le mélangeur. Le signal composite est appliqué à un échantillonneur sollicité par des impulsions d'échantillonnage d'une fréquence prédéterminée $f_e$. L'échantillonneur est suivi d'un amplificateur opérationnel 7, monté en mémorisateur de tension, et d'un convertisseur analogique digital 8. Ce dernier coopère avec l'unité de traitement de donnée 9, forme avantageusement par un microprocesseur. Le convertisseur fournit au microprocesseur par un bus 10 les valeurs des tensions échantillonnées sous forme numérique. Les ordres de conversion donnés par le microprocesseur par une liaison symbolisée par la référence 11 est synchrone de l'impulsion d'échantillonnage de fréquence $f_e$. Le microprocesseur est programmé pour produire par une opération d'analyse fréquentielle une deuxième série de signaux comprenant les mêmes composantes de fréquence que le signal composite à la sortie du filtre 5 et établit les phases et les amplitudes des signaux ainsi produits dans le récepteur par une mise en corrélation de ces signaux avec les échantillons SM produits par l'échantillonneur 6, en vue de la détermination des données permettant d'identifier la position de récepteur par rapport aux postes émetteurs du système RANA.

Le principe inhérent à la présente invention réside dans le fait que l'on transforme les signaux radio-électriques reçus, de fréquence élevée, en signaux de plus basse fréquence de valeur telle que les fréquences ainsi obtenues constituent des multiples ou harmoniques de la fréquence $\Delta f$ séparant deux signaux de radio-fréquence reçus par l'antenne 1. Il suffit à cette fin de choisir de façon appropriée la fréquence de l'oscillateur pilote 4 et de tenir également compte du fait que l'échantillonneur 6 suivi du mémorisateur de tension 7 a le même effet qu'un mélangeur et effectue donc une transposition supplémentaire des fréquences, que subit le signal composite à la sortie du filtre 5. Selon l'invention on fait de telle sorte que les signaux F' de basse fréquence après la transposition obéissent à la relation suivante:

$$F' = \Delta f \times (N + N_0)$$

Dans cette relation $N_0$ constitue un nombre entier et détermine le multiple le plus bas que l'on désire traiter. Cette relation des fréquences à traiter permet de recréer à l'aide du microprocesseur gladite deuxième série de signaux comprenant les mêmes composantes de fréquence que le signal obéissant à la relation précitée et de déterminer les caractéristiques de ces composantes en les mettant en corrélation avec les échantillons fournis par l'échantillonneur 6. A cette fin le microprocesseur effectue une analyse fréquentielle basée sur un développement en série de Fourier.

Pour faciliter la description de l'invention, il convient, avant de décrire les différentes opérations à effectuer par le microprocesseur, d'indiquer les valeurs caractéristiques du système RANA et d'un mode de réalisation du récepteur suivant la présente invention. Bien entendu, l'invention pourrait être adaptée à d'autres systèmes tout en respectant le principe de l'invention.

Chaque station RANA émet une fréquence permanente qui peut être écrite en appliquant le principe qui est à la base de l'invention de la manière suivante

$$F=285,5 \text{ KHz}+(N+6)\ 6,25 \text{ Hz.}$$

Dans cette relation N est le numéro de la station émettrice considérée, la valeur de 6,25 Hz constitue la basse fréquence $\Delta f$ séparant deux signaux RANA adjacents émis, tandis que $N_0$ est ici constitué par le nombre 6.

L'oscillateur pilote 4 produit une fréquence de 285 KHz, le filtre unique 5 présente une fréquence centrale de 500 Hz et une bande passante de 430 à 570 Hz. La fréquence d'échantillonnage $f_e$ est de 400 Hz. Deux impulsions d'échantillonnage sont donc espacées de 2,5 millisecondes. En tenant compte de ces valeurs et de l'effet de transposition de fréquence supplémentaire, produit par l'échantillonneur 6 et le mémorisateur de tension 7, le signal vu par le convertisseur 8 est de 100 Hz, ce que est la différence entre la fréquence d'entrée de 500 Hz et la fréquence d'échantillonnage de 400 Hz.

Le principe du traitement effectué par le microprocesseur 9 est fondé sur la considération que les composantes du signal composite, dans la mesure où celui-ci constitue une fonction périodique de période $1/6,26$ Hz=160 millisecondes peuvent être isolées par calcul. Etant donné que toutes les composantes sont des multiples de la fréquence $\Delta f=6,25$ Hz, le signal composite $F'(t)$, du fait qu'elle est périodique, peut être exprimée sous forme d'une série trigonométrique (en négligeant la composante $a_0$) suivante:

$$(1)\qquad F'(t)=\sum_{n=0}^{\infty}(an \cos n\ \omega t+bn \sin n\omega t)$$

$\omega$ étant la fréquence fondamentale

$$2\pi\times\Delta f=2\pi\times 6,25 \text{ Hz;}$$

an, bn constituant les coefficients d'amplitude et n étant un nombre entier désignant le rang de l'harmonique des coefficients en et bn.

A partir des coefficients an, bn, on peut déterminer l'amplitude d'un signal d'harmonique du rang n suivant l'expression $[an^2+bn^2]^{1/2}$ et l'angle formé par ces coefficients suivant l'expression

$$\varphi n=\text{Arctg}\frac{bn}{an}$$

Les coefficients an et bn s'obtiennent selon un développement de Fourier selon les relations suivantes:

$$(2)\qquad an=2\int_0^T F'(t) \cos 2\pi n\frac{t}{T}dt$$

$$bn=2\int_0^T F'(t) \sin 2\pi n\frac{t}{T}dt$$

T constituant la période fondamentale de 160 millisecondes=1/6,25.

Pour permettre le calcul par le microprocesseur, les intégrales sont remplacées par des sommes finies. Dans l'exemple présent, on choisit de faire 64 sommes espacées de 2,5 millisecondes et on obtient les expressions suivantes:

$$(3)\qquad an=\sum_{t=0}^{63} F'(t) \cos\left(2\pi n\frac{t\times 2,5\ 10^{-3}}{160\ 10^{-3}}\right)$$

$$bn=\sum_{t=0}^{63} F'(t) \sin\left(2\pi n\frac{t\times 1,5\ 10^{-3}}{160\ 10^{-3}}\right)$$

Les coefficients constants sont enlevés du fait que seules les valeurs relatives des signaux soit intéressantes.

Les angles sont exprimés ici en radian. Il convient dans le système de calcul du microprocesseur de les exprimer en 256 ièmes de tour. A cette fin on divise l'angle par $2\pi$ et le multiplie 256. On obtient les relations suivantes:

$$(4)\qquad an=\sum_{t=0}^{63} F'(t) \cos (4\ nt)$$

$$bn=\sum_{t=0}^{63} F'(t) \sin (4\ nt)$$

En choisissant $N_0=6$, on peut exprimer le nomre n par $N+6$ et on obtient:

$$(5)\qquad an=\sum_{t=0}^{63} F'(t) \cos 4\,t\,(N+6)$$

$$bn=\sum_{t=0}^{63} F'(t) \sin 4\,t\,(N+6)$$

Dans le cadre de l'invention, le signal composite $F'(t)$ prend successivement les valeurs $F_e'$ des échantillons produits par l'échantillonneur 6.

Selon l'invention on cherche à annuler l'angel $\varphi$, c'est-à-dire bn. A cette fin on élabore:

$$(6)\qquad an=\sum_{t=0}^{63} F'_e(t) \cos (4t\ (N+6)+PE_n)$$

$$bn=\sum_{t=0}^{63} F'_e(t) \sin (4t\ (N+6)+PE_n)$$

Dans ces relations le terme $PE_n$ constitue une

valeur de phase initiale constante. Il s'agit de la phase du signal radio-électrique correspondant à la basse fréquence ayant le rang de l'harmonique n par rapport à la fréquence locale produite dans le récepteur c'est-à-dire le signal d'échantillonnage $f_e$.

Selon l'invention on prédéterminé pour une fréquence à traiter de numéro N une phase $PE_n$, qui est donc une phase estimée quantifiée en fractions de tour et le rôle du traitement est de comparer cette phase estimée à la phase reçue pour corriger éventuellement la phase estimée selon le principe d'un asservissement. Comme il est dit plus haut, on cherche à annuler l'angle $\varphi$, c'est-à dire le coefficient d'amplitude bn indique par les relations susmentionnées.

En partant de la phase estimée $PE_n$, le micro-processeur déterminé la phase réelle en mettant en corrélation successivement les coefficients d'amplitude an, bn calculés avec les échantillons fournis par le convertisseur 8. Autrement dit, selon la présente invention on réalise une analyse programmée par microprocesseur pour obtenir pour toute fréquence une indication de décalage de phase variant comme le sinus de ce décalage, en vue d'asservir une phase estimée programmée à une phase reçue identifiée dans le groupe par le numéro de la station émettrice correspondante.

Il est à noter que la phase $PE_n$ finalement établie par le microprocesseur est exploitable directement pour la radio-localisation. C'est la phase du signal de fréquence n à l'instant marqué par t=0 par le microprocesseur. Par la suite on n'utilise que des différences de phase prises par rapport à un même temps d'origine pour définir des différences de temps de propagation entre émetteurs et récepteur.

Dans le mode de réalisation concret d'un récepteur selon la présente invention, six fréquences distinctes, choisies parmi les 18 fréquences RANA possibles sont traitées simultanément. Dans ce mode de réalisation, le temps est découpé en segments de 240 millisecondes=96 temps de 2,5 millisecondes. Les opérations d'échantillonnage et les prélèvements au convertisseur s'effectuent pendant les dernières 160 millisecondes de t=32 à t=95 compris.

Au départ, lorsque t=31 on place les moyens totalisateurs sin et cos à 0, c'est-à-dire des moyens qui effectuent les cumuls suivant les expressions 6. A ce temps t=31 les coefficients d'amplitude an, bn présentent la valeur de phase qui est égale à $PN_n$, c'est-à-dire à la valeur estimée.

Au temps t=32, correspondant à 1 dans la formule, il faut tenir compte que l'angle a évolué d'une valeur égale à 4(N+6). Ainsi la phase totale ou temps t=32 présente la valeur $PE_n$+4(N+6). On calcule également le sinus de l'angle déterminé par l'expression et on le multiplie par la valeur du convertisseur, qui vient d'être prélevée. Ce résultat est ajouté à la valeur obtenue à l'instant de temps t=31. On fait de même pour le cosinus.

Au temps t=33 (2 de la formule) on ajoute à la phase totale à nouveau la valeur 4(N+6) et on fait également le cumul pour les sinus et cosinus. Les mêmes opérations sont faites pour chacune des fréquences.

Ainsi, pour chaque fréquence on effectue, à partir de la phase estimée la variation de phase selon 4(N+6) d'un échantillon au suivant, on totalise la phase, le sinus et le cosinus, établit l'amplitude moyennée et la moyenne des valeurs absolues des écarts de la phase mesurée par rapport à la phase estimée PE. Les différentes totalisations sont interprétées toutes les 240 millisecondes à t=5. Les totalisations du sinus servent principalement à corriger la valeur PE. L'amplitude instantanée est calculée selon

$$[(TOTAL\ SIN)^2+(TOTAL\ COS)^2]^{1/2}$$

et sert à corriger l'amplitude moyenne. La valeur absolue de TOTAL SIN sert à corriger la moyenne des valeurs instantanées. Ceci permet d'éliminer des parasites c'est-à-dire le bruit radio-électrique et donne une information sur l'exactitude des amplitudes.

De plus, le TOTAL SIN est cumulé dans un registre pour les fréquences. Le résultat sert à corriger l'oscillateur pilote 4 qui commande la précision de la transposition des fréquences dans la bande passante du filtre 5.

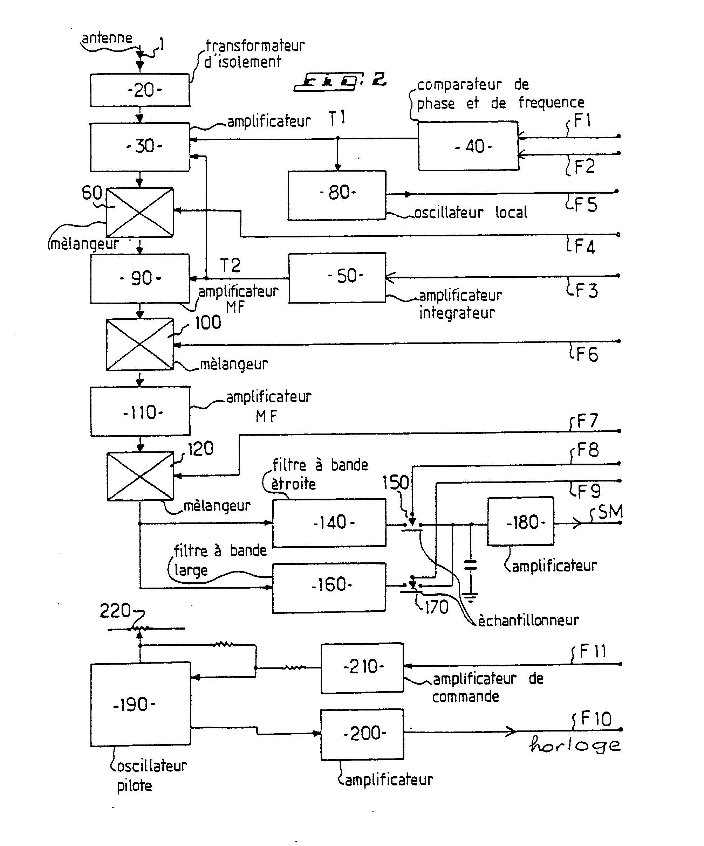

En se référant maintenant à la figure 2, on va décrire tout d'abord le système d'acquisition et de traitement des signaux de radio-fréquence d'un système de radio-navigation tel que le système dit RANA émettant des fréquences dans la gamme de 285 à 420 kilohertz. Bien entendu ces valeurs ne sont données qu'à titre d'exemple sans que le récepteur selon l'invention soit limité à ces valeurs. Ce système comprend au moins le filtre et l'échantillonneur représentés en figure 1.

Pour faciliter la compréhension de la description, on indiquera ci-après les valeurs de fréquence spécifique des différentes composantes du récepteur.

Au vu de la figure 2, on constate que les signaux reçus par l'antenne 1 sont transmis par un transformateur d'isolement 20 à un amplificateur haute fréquence 30 qui est susceptible d'être accordé à des fréquences entre 280 et 420 kiloHertz sous l'effet d'une tension de commande automatique de fréquence T1 obtenue à partir d'un signal de référence de 2 kiloHertz F1 et d'un signal d'asservissement de 2 kiloHertz F2 fourni par le système logique, par l'intermédiaire d'un comparateur de phase et de fréquence 40. Le gain de l'amplificateur 30 est réglable par une tension de commande automatique de gain T2 qui est produite par un amplificateur intégrateur 50 à partir d'un signal logique F3 issu du système logique. Un premier mélangeur 60 est disposé en aval de l'amplificateur haute fréquence 30. Il est destiné à transposer le signal qu'il reçoit à une fréquence de 59,6 kilo Hertz. Ce mélangeur est commandé par un signal F4 produit par division par 10 de la fréquence F5 produite par un oscillateur local 80 sous l'effet de la tension T1 de commande automatique de fréquence. Le signal de sortie de 59,6 kiloHertz du mélangeur 60 est transmis par un amplificateur moyenne fréquence 90, qui est également commandé par la tension T2 de commande automatique de gain, à un second mélangeur 100 adapté pour transposer le signal reçu à une fréquence de 4,5 kiloHertz. Ce mélangeur est commandé par un signal F6 et 64 kiloHertz issu du système logique. Un amplificateur moyenne fréquence 110 transmet le signal de sortie du mélangeur 100 à un troisième mélangeur 120 commandé par un signal logique de 4 kiloHertz F7 provenant du système logique. Un filtre à bande étroite 140, correspondant au filtre 5 de la figure 1 et accordé à 500 Hertz, transmet le signal séquentiel du système RANA à un échantillonneur 150 correspondant à l'échantillonneur 6. Un filtre 160 à bande large de 430 à 570 Hertz transmet les basses fréquences à la sortie du mélangeur 120 obtenues à partir des fréquences permanentes du système RANA à un échantillonneur 170. Les deux échantillonneurs 150 et 170 sont commandés par des impulsions F8 ($=f_e$) de 400 Hertz et F9 de 400 Hertz, issues du système logique. Les échantillonneurs fournissent alternativement à travers un amplificateur 180 correspondant à l'amplificateur 7, au système logique des signaux de mesures SM obtenus par le traitement de transposition et d'échantillonnage auquel les signaux de radiofréquence reçus par l'antenne 1 ont été soumis.

La figure 2 montre encore que le récepteur selon l'invention comporte un oscillateur pilote de fréquence nominale 190 par exemple de 4096 kiloHertz, qui est destiné à fournir au système logique le signal pilote ou d'horloge F10, après amplification par un amplificateur 200. A l'oscillateur 190 est associé un dispositif de réglage comprenant un potentiomètre 220 permettant un ajustement de la fréquence centrale de l'oscillateur. Ce potentiomètre constitue un moyen de réglage gros. La fréquence centrale est affinée par un signal de commande F11 issu du système logique. Ce signal est amplifié par un amplificateur de commande 210 ayant un rôle intégrateur et transmis à l'oscillateur 190 et au potentiomètre 220. La résistance de sortie règle la plage d'action du signal de commande sur la fréquence pilote à environ+ou−6 Hertz.

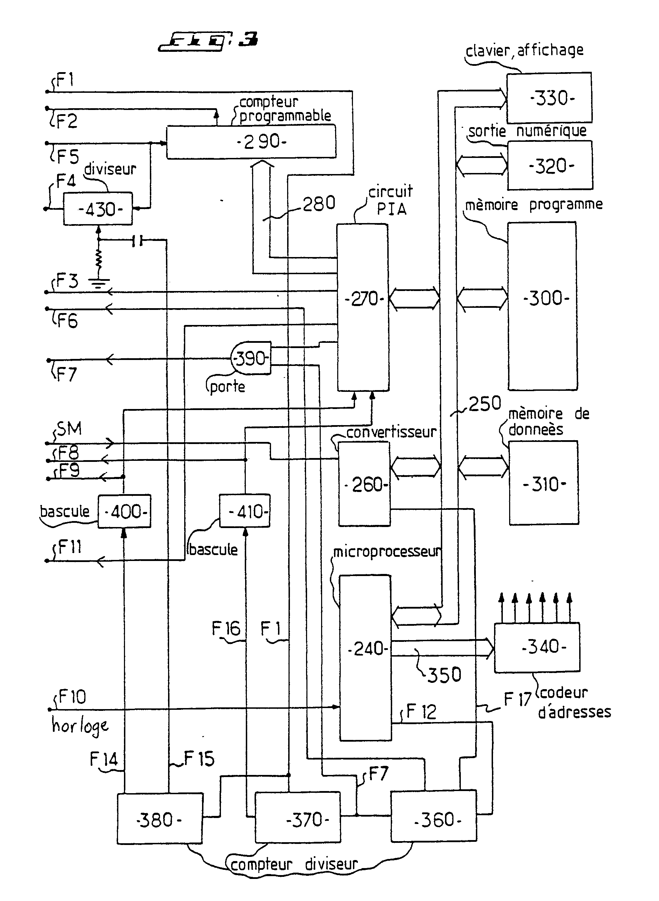

On décrira ci-après le système logique, comprenant au moins l'unité de traitement de la figure 1, en se reportant à la figure 3, qui présente le schéma-bloc ou synoptique de ce système logique. On trouve sur la partie gauche tous les signaux de fonctionnement destinés à être transmis au système d'acquisition et de traitement représenté à la figure 2, et les signaux provenant du système d'acquisition et destinés au système logique.

Ce système comprend un microprocesseur 240, correspondant à l'unité précitée, qui est relié par un bus de données 250 bidirectionnel à un convertisseur analogique-numérique 260, correspondant au convertisseur 8, duquel il reçoit les signaux de mesure SM des phases et d'amplitude des signaux de réception et à un circuit 270 pour le transfert des données programmées de fréquences de réception par un bus 280 à un compteur programmable 290 et pour générer la tension F3 de commande automatique du gain et du signal d'asservissement F11 pour l'oscillateur pilote 190.

Le microprocesseur 240 est également relié par le bus 250 à un dispositif mémoire programme 300, à un dispositif mémoire de données 310 du type RAM, à un dispositif clavier et d'affichage 320 et un dispositif de sortie numérique 330. Les circuits 260, 270, 300 et 330 sont habituellement adressable par l'intermédiaire d'un codeur d'addresses 350 relié par un bus 350 au microprocesseur 240.

Le microprocesseur 240 comprend un compteur diviseur interne des fréquences qui est adapté pour produire un signal F12 qui présente dans le récepteur ici donné à titre d'exemple une fréquence de 1024 kiloHertz. Le signal F12 est appliqué à une série de 3 compteurs diviseurs 360, 370, 380 destinés à effectuer une division par respectivement 256,8 et 10 pour fournir les signaux de référence nécessaires au cadencement des opérations d'acquisition et de filtrage à effectuer par le système selon la figure 2. Ainsi le compteur diviseur par 256, qui porte la référence 360, produit à sa sortie le signal F7 de 4 kiloHertz qui est appliqué à travers une porte 390 au mélangeur 120. Le compteur diviseur 370 qui effectue une division par 8 produit le signal de référence F1 de 2 kiloHertz qui sera appliqué au comparateur 40 destiné à produire la tension de commande automatique de fréquence pour l'amplificateur haute fréquence 30. Ce signal F1 est également transmis au diviseur 380 qui produit deux signaux F14 et F15 de respectivement 400 Hertz et 200 Hertz. Le compteur diviseur 370 engendre en outre un signal F16 de 500 Hertz. Les signaux F14 et F16 parviennent chacun à une bascule 400, 410 destinée à produire respectivement les impulsions d'échantillonnage F9 et F8 pour les échantillonneurs 150, 160 du système d'acquisition et de traitement. Les signaux F8 et F9 constituent également les signaux d'interruption destinés à cadencer le programme du récepteur et sont appliqués à cette fin au circuit 270. Le signal F15 de 200 Hertz constitue un signal de référence destiné à synchroniser un diviseur par 10 430 qui a pour fonction de produire à partir du signal F5 fourni par l'oscillateur local 80 le signal F4 qui est appliqué au mélangeur 60. Le signal F5 est également reçu par le compteur programmable 280 dont le taux de division est réglé par le circuit 270 de manière à produire le signal d'asservissement F2 dans le but d'aligner le récepteur successivement sur les différentes fréquences RANA émises dans la gamme de 285 à 420 kiloHertz.

Concernant le fonctionnement du récepteur qui vient d'être décrit à titre d'exemple, celui-ci a été décrit de façon détaillée au début du présent texte descriptif. On transforme les signaux radio-électriques reçus en une première série de signaux de basse fréquence dont chacune constitue une harmonique ou un multiple de la fréquence d'écartement de signaux radio-électriques adjacents par une transposition appropriée à l'aide des mélangeurs 60, 100 et 110 dont les fréquences de commande sont choisies en conséquence. Le signal composite formé par la superposition des signaux de basse fréquence ainsi obtenu est échantillonné par les échantillonneurs 150 et 170. Le signal de mesure SM ainsi obtenu est transmis à l'unité de calcul c'est-à-dire au convertisseur 260 et au microprocesseur 240. L'unité centre produire localement une deuxième série de signaux de plus base fréquence, qui comporte les mêmes composantes que ledit signal comporte et détermine les valeurs des signaux locaux par corrélation avec les échantillons. Les différentes opération que l'unité de traitement exécute à cette fin ont été décrites de façon détaillée au début du présent texte descriptif. Dans le cas de la présente invention il importait principalement de décrire la nature des signaux de commande et de cadencement qui sont nécessaires au fonctionnement du système d'acquisition et de traitement selon la figure 2 et du système logique objet de la figure 3. La nature et les caractéristiques essentielles de ces signaux ressort de façon évidente de la description des deux systèmes, qui vient d'être faite.

Il est à noter que les valeurs de fréquences n'ont été données qu'à titre d'exemple. Ces valeurs peuvent être différentes et sont bien entendu fonction des signaux de radio-fréquence destinés à être reçus et traités par le récepteur selon l'invention.

**Revendications**

1. Procédé de traitement d'une série de signaux radio-électriques présentant un même écart d'une basse fréquence $\Delta f$ entre signaux adjacents, notamment des signaux de radio-fréquence d'un système de radio-navigation, pour permettre par exploitation des phases des signaux reçus, la localisation d'un poste récepteur, selon lequel on transforme la série des signaux reçus de radio-fréquence en une série de signaux de plus basse fréquence et assure l'état séparé de ces fréquences, caractérisé en ce que l'on transforme lesdits signaux radio-électriques reçus en une première série de signaux de plus basse fréquence dont chacune constitue une harmonique ou un multiple de ladite fréquence d'écartement $\Delta f$, qu'on échantillonne à une fréquence prédéterminée ($f_e$) le signal composite desdits signaux de plus basse fréquence et on produit localement, par une opération d'analyse fréquentielle, une deuxième série de signaux de plus basse fréquence, qui comporte les mêmes composantes de fréquence que ledit signal composite et on détermine, par corrélation avec des (SM) issus de l'échantillonnage, les phases et, le cas échéant, les amplitudes de ces signaux locaux.

2. Procédé selon la revendication 1, caractérisé en ce que l'on produit localement ladite deuxième série par une analyse de signaux programmée à l'aide d'un unité de traitement telle qu'un ordinateur ou microprocesseur.

3. Procédé selon des revendications précédentes, caractérisé en ce que l'on prédétermine, par estimation et pour chaque signal reçu, une phase que l'on vérifie et adapte, en tenant compte des valeurs des échantillons, en vue d'asservir la phase estimée à la phase du signal reçu correspondant; la phase estimée asservie étant directement exploitable pour la radio-localisation.

4. Procédé selon l'une des revendications précédentes, caractérisé en ce que l'on exprime ladite deuxième série des signaux produite dans le poste récepteur sous forme d'une série trigonométrique et on détermine les coefficients d'amplitude de chaque composante de cette série selon un développement de Fourier, dans lequel on remplace les intégrales par des sommes finies que l'on cumule.

5. Procédé selon l'une des revendications précédentes, caractérisé en ce que la mesure des amplitudes individuelles est utilisée pour obtenir des indications relatives à la qualité des signaux traités.

6. Récepteur pour la mise en oeuvre du procédé selon l'une des revendications 1 à 5 comportant un système d'acquisition et de traitement de signaux reçus, qui comprend un mélangeur (3) destiné à transformer la série des signaux reçus de radio-fréquence en une première série de signaux de plus basse fréquence, un dispositif de filtrage (5) des signaux transformés et un dispositif de détermination des phases des signaux obtenues, caractérisé en ce que le système d'acquisition et de traitement comporte un seul filtre (5) monté en aval du mélangeur (3) et adpaté pour laisser passer le signal composite desdits signaux de plus basse fréquence présent à la sortie du mélangeur et un échantillonneur (6) destiné à échantillonner ledit signal composite filtré à une fréquence prédéterminée ($f_e$); une unité de traitement de données (9) adaptée pour produire, par une opération d'analyse fréquentielle, une deuxième série de signaux comprenant les mêmes composantes de fréquence que ledit signal composite et pour déterminer les phases et, le cas échéant, les amplitudes des signaux ainsi produits dans le récepteur, par corrélation avec les échantillons (SM) fournis par l'échantillonneur (6).

7. Récepteur selon la revendication 6, caractérisé en ce que l'unité de traitement (9) précité, telle qu'on ordinateur ou microprocesseur, fait partie d'un système logique adapté pour assurer la coopération et le fonctionnement synchrone des dispositifs constitutifs du système d'acquisition et de traitement et du système logique précité.

8. Récepteur selon l'une des revendications 6 ou 7, caractérisé en ce qu'un convertisseur analogique-numérique (8; 260) est monté entre l'échantillonneur (6; 150) et l'unité de traitement (9; 240).

9. Récepteur selon l'une des revendications 6 à 8, caractérisé en ce qu'un amplificateur opérationnel (7; 180), monté en mémorisateur de tension, est monté en aval de l'échantillonneur (6; 150).

10. Récepteur selon la revendication 6 caractérisé en ce que le système d'acquisition et de traitement comprend un montage en série de moyens amplificateurs (30, 90, 110) et de moyens mélangeurs (60, 100, 120); les moyens amplificateurs comportant un amplificateur haute fréquence (30) accordé sous l'effet d'une tension (T1) de commande automatique de fréquences, issue du système logique, et les moyens mélangeurs étant commandés par des signaux (F4, F6, F7) produits par le système logique.

11. Récepteur selon l'une des revendications 6 ou 10, caractérisé en ce que le système d'acquisition et de traitement comprend un premier montage en série d'un filtre à bande étroite (140) et d'un échantillonneur (150) et un deuxième montage en série d'un filtre (160) à bande large et d'un deuxième échantillonneur (170), les deux montages étant montés en parallèle en aval du dispositif mélangeur.

12. Récepteur selon l'une des revendications 6 à 11, caractérisé en ce qu'il comprend un oscillateur pilote de fréquence nominale (190), pourvu de moyens tels qu'un potentiomètre (220) permettant un réglage gros de la fréquence centrale et de moyens assurant un réglage fin par un signal de commandes (F11) issu du système logique, le signal pilote (F10) de l'oscillateur (190) étant appliqué à l'unité de traitement (240) du système logique.

13. Récepteur selon la revendication 12, caractérisé en ce que l'unité de traitement (240) comprend un compteur diviseur interne de fréquence, adapté pour produire à partir du signal pilote (F10) un signal de sortie (F12) permettant la production par division de fréquence des signaux de référence (F6, F1, F14, F15, F16, F17) nécessaires au cadencement des opérations de filtrage et d'acquisition.

14. Récepteur selon l'une des revendications 12 ou 13, caractérisé en ce que l'unité de traitement (240) est reliée par un bus de données bidirectionnel (250) à un convertisseur analogique-numérique (260) duquel il reçoit les signaux de mesure des phases et d'amplitude (SM) des signaux reçus par le récepteur et à un circuit adapté pour assurer le transfert des données programmées des signaux reçus et pour la production d'une tension (T2) de commande automatique du gain des moyens amplificateurs (30), et du signal (F11) d'asservissement de l'oscillateur pilote, le circuit (270) recevant aussi des signaux d'interruption qui cadencent le programme du récepteur.

15. Récepteur selon la revendication 14, caractérisé en ce que le circuit de transfert et de commande (270) est relié par un bus (280) à un compteur programmable (290) dont il règle le taux de division de manière à créer la fréquence nécessaire pour aligner le récepteur successivement sur les différents signaux reçus.

16. Récepteur selon l'une des revendications 14 ou 15, caractérisé en ce que l'unité de traitement (240) est reliée à un codeur d'adresse (340) pour l'adressage habituel d'un dispositif mémoire programme (300), d'un dispositif mémoire de données (310), d'un dispositif clavier et d'affichage (320) d'un dispositif de sortie numérique (330), du convertisseur analogique-numérique (260) et du circuit de transfert de commande (270).

**Patentansprüche**

1. Verfahren zur Verarbeitung von einer Folge von radio-elektrischen Signalen mit demselben Abstand von einer niedrigen Frequenz $\Delta f$ zwischen einander folgenden Signalen, insbesondere von Radio-Frequenz-Signalen eines Radio-Navigations-Systems, um, durch Benutzung der Phasen der empfangenen Signale, die Lokalisierung eines Empfängers zu ermöglichen, demäß dem man die Folge der empfangenen Radio-Frequenz-Signale in eine Folge von Signalen mit einer niedrigeren Frequenz umwandelt und man den getrennten Zustand dieser Frequenzen durchführt, dadurch gekennzeichnet, daß man die besagten empfangenen radio-elektrischen Signale in eine erste Folge von Signalen mit niedrigeren Frequenzen umwandelt, von denen jede eine Oberschwingung oder ein Vielfaches der besagten Abstandsfrequenz $\Delta f$ bildet man das zusammengesetzte Signal der besagten Signale mit einer niedrigeren Frequenz bei einer vorbestimmten Frequenz (fe) zerhackt, und man, durch eine Frequenzanalyse, eine zweite Folge von Signalen mit niedrigeren Frequenzen, ötlich erzeugt, wobei diese Folge dieselben Frequenzkomponenten wie das besagte zusammengesetzte Signal aufweist und man, durch Korrelation mit aus dem Zerhacker kommenden Proben (SM), die Phasen und, gegebenenfalls, die Amplituden dieser örtlichen Signale bestimmt.

2. Verfahren nach Anspruch 1, dadurch gekennzeichnet, daß man die besagte zweite Folge durch eine programmierte Signalanalyse, anhand einer Verarbeitungseinheit wie einem Computer oder einem Mikroprozessor ötlich erzeugt.

3. Verfahren nach einem der vorangehenden Ansprüche, dadurch gekennzeichnet, daß man, durch Schätzung und für jedes empfangene Signal, eine Phase vorbestimmt, die man nachprüft und adaptiert, unter Berücksichtigung der Werte der Proben, zur Steuerung der geschätzten Phase durch die Phase des entsprechenden empfangenen Signals, wobei die gesteuerte geschätzte Phase für die Radio-Navigation direkt benutzbar ist.

4. Verfahren nach einem der vorangehenden Ansprüche, dadurch gekennzeichnet, daß man die besagte, im Empfänger erzeugte zweite Signalfolge in Form einer trigonometrischen Folge ausdrückt, und daß man die Amplitudenkoffizienten jeder Komponente dieser Folge gemäß einer Fourier-Entwicklung bestimmt, in der man die Integralen durch begrenzte Summe, die man kumuliert, ersetzt.

5. Verfahren nach einem der vorangehenden Ansprüche, dadurch gekennzeichnet, daß die Messung der einzelnen Amplituden, um die Qualität der verarbeiteten Signale betreffenden Angaben zu erhalten, verwendet wird.

6. Empfänger zur Durchführung des Verfahrens nach einem der Ansprüche 1 bis 5 mit einem System zur Erfassung und Verarbeitung von empfangenen Signalen, das einen Mischer (3) zur Umwandlung der Folge der empfangenen Radio-Frequenz-Signale in eine erste Folge von Signalen mit einer niedrigeren Frequenz, eine Vorrichung (5) zum Filtern der umgewandelten Signale und eine Vorrichtung zur Bestimmung der Phasen der empfangenen Signale umfaßt, dadurch gekennzeichnet, daß das Erfassungs- und Verarbeitungssystem einen einzigen, dem Mischer (3) nachgeschalteten Filter (5), der dazu angepaßt ist, das am Ausgang des Mischers vorhandene zusammengesetzte Signale der besagten Signale mit einer niedrigeren Frequenz durchzulassen, und einen Zerhacker (6) zum Zerhacken des besagten, an einer vorbestimmten Frequenz (fe) filterten zusammengesetzten Signals, eine Daten-verarbeitungseinheit (9) zur Erzeugung, durch Frequenzanalyse, einer zweiten Signalfolge mit denselben Frequenzkompenenten wie das besagte zusammengesetzte Signal und zur Bestimmung der Phasen und, gegebenenfalls, der Amplituden der im Empfänger so erzeugten Signale, durch Korrelation mit den, von dem Zerhacker (6) gelieferten Proben (SM) aufweist.

7. Empfänger nach Anspruch 6, dadurch ge-kennzeichnet, daß die besagte Verarbeitungsein-heit (9), wie ein Computer oder ein Mikroprozessor, zu einem logischen System gehört, das dazu angepaßt ist, die Zusammenarbeit und den synchronen Betrieb der, das Erfassungs- und Verarbeitungssystem und das besagte logische System bildenden Einrichtungen durchzuführen.

8. Empfänger nach einem der Ansprüche 6 oder 7, dadurch gekennzeichnet, daß ein Analog-Digital-Umsetzer (8; 260) zwischen dem Zerhacker (6; 150) und der Verarbeitungseinheit (9; 240) geschaltet ist.

9. Empfänger nach einem der Ansprüche 6 bis 8, dadurch gekennzeichnet, daß ein als Spannungsspeicher geschalteter Operationsverstärker (7; 180) dem Zerhacker (6; 150) nachgeschaltet ist.

10. Empfänger nach Anspruch 6, dadurch gekennzeichnet, daß das Erfassungs- und Verarbeitungssystem hintereinander geschaltete Verstärkungsmittel (30, 90, 110) und Mischungsmittel (60, 100, 120) aufweist, wobei die Verstärkungsmittel einen, durch eine, aus dem logischen System kommende automatische Scharfabstimmungsspannung (T1) auf die rich-tige Frequenz abgestimmten Hochfrequenzver-stärker (30) aufweisen, und wobei die Mischungsmittel von, vom logischen System erzeugten Signalen (F4, F6, F7) gesteuert sind.

11. Empfänger nach einem der Ansprüche 6 oder 10, dadurch gekennzeichnet, daß das Erfassungs- und Verarbeitungssystem eine erste Hintereinanderschaltung eines schmalbandigen Filters (140) und eines Zerhackers (150) und eine zweite Hintereinanderschaltung eines breitbandigen Filters (160) und eines zweiten Zerhackers (170) aufweist, wobei beide Schaltungen der Mischungseinrichtung parallel nachgeschaltet sind.

12. Empfänger nach einem der Ansprüche 6 bis 11, dadurch gekennzeichnet, daß er einen Soll-Frequenz-Steueroszillator (190), der Mittel wie ein, eine grobe Einstellung der Bandmitten-Frequenz ermöglichendes Potenziometer (220) und Mittel, die eine feine Einstellung durch ein, aus dem logischen System kommendes Steuersignal (F11), durchführen, aufweist, wobei das Steuersignal (F10) des Oszillators (190) der Verarbeitungseinheit (240) des logischen Systems angelegt ist.

13. Empfänger nach Anspruch 12, dadurch gekennzeichnet, daß die Verarbeitungseinheit (240) einen inneren Zähler-Frequenzteiler aufweist, der dazu angepaßt ist, aus dem Steuersignal (F10) ein Ausgangssignal (F12) zu erzeugen, das die Erzeugung, durch Frequenzteilung, von den, zum Arbeitstakt der Filter- und Erfassungsvorgänge notwendigen Bezugssignalen (F6, F1, F14, F15, F16, F17) ermöglicht.

14. Empfänger nach einem der Ansprüche 12 oder 13, dadurch gekennzeichnet, daß de Verarbeitungseinheit (240) durch einen Zwei - Richtungsdaten - Übertragungsweg (250) mit einem Analog-Digital-Umsetzer (260), von dem er Phasen- und Amplitudenmessignale (SM) der vom Empfänger empfangenen Signale empfängt, und mit einem, zur Überführung der programmierten Daten der empfangenen Signale und zur Erzeugung einer Spannung (T2) zur Selbst-steuerung des Verstärkungsgrads der Ver-stärkungsmittel (30) und des Signals (F11) zur Steuerung des Steuer-Oszillators verbunden ist, wobei die Schaltung (270) den Arbeitstakt des Programms des Empfängers bestimmende Unterbrechungssignale auch empfängt.

15. Empfänger nach Anspruch 14, dadurch gekennzeichnet, daß die Übertragungs- und Steuerungsschaltung (270) durch einen Daten-übertragungsweg (280) mit einem programmierbaren Zähler (290) verbunden ist, dessen Teilungsgrad durch die Übertragungs- und Steuerungsschaltung so geregelt ist, daß die, zur aufeinanderfolgenden Einstellung des Emp-fängers gemäß den versschiedenen emp-fangenen Signale, benötigte Frequenz erzeugt wird.

16. Empfänger nach einem der Ansprüche 14 oder 15, dadurch gekennzeichnet, daß die Ver-arbeitungseinheit (240) mit einem Adressen-kodierer (340) zur gewöhnlichen Adressierung eines Programmspeichers (300), eines Datenspeichers (310), einer Tastatur- und Anzeigevorrichtung (320) einer numerischen Ausgangsvorrichtung (330), des Analog - Digital - Umsetzers (260) und der Steuerungs- und Übertragungsschaltung (270) verbunden ist.

**Claims**

1. Method for processing a series of radio signals presenting a same interval of low frequency ($\Delta f$) between adjacent signals, especially the radio signals of a radio navigation system to allow, by using the phases of the signals received, the location of a receiver set, according to which the series of radio signals received is converted into a series of signals of lower frequency and ensures the separate state of these frequencies, characterized in that the said radio signals received are converted into a series of signals of lower frequency, each of which constitutes a harmonic or a multiple of the said interval frequency ($\Delta f$), in that the composite signal of the said signals of lower frequency is sampled at a predetermined frequency ($f_e$) and in that there is locally produced, through an operation of frequency analysis, a second series of signals of lower frequency which includes the same frequency components as the said composite signal and there are determined the phases and, possibly the amplitudes of these local signals through correlation with samples (SM) from the sampling.

2. Method according to claim 1, characterized in that the said second series is produced locally by a programmed signal analysis by means of a processing unit such as a computer or a microprocessor.

3. Method according to the preceding claims, characterized in that there is predetermined, by an estimation and for each signal received, a phase which is checked and adapted by taking into account the values of the samples so as to cause the estimated phase to follow up the phase of the corresponding received signal, this estimated follow-up phase being directly usable for radio location.

4. Method according to one of the preceding claims, characterized in that the said second series of signals produced in the receiver is expressed in the form of a trigonometric series and the amplitude coefficient of each component of this series is determined according to a development of the Fourier series, wherein the integrals are replaced by finite sums which are cumulated.

5. Method according to one of the preceding claims, characterized in that the measurement of the individual amplitudes is used to obtain indications relating to the quality of the processed signals.

6. Receiver for carrying out the method of one of claims 1 to 5 comprising a system for the acquisition and the processing of received signals, which includes a mixer (3) intended to transform the series of radio signals received into a first series of signals of lower frequency, a device (5) for filtering the transformed signals and a device for determining the phases of the signals obtained, characterized in that the system for the acquisition and the processing has only one filter (5) mounted downstream of the mixer (3) and adapted to allow the passage of the composite signal of the said signals of lower frequency at the output of the mixer and a sampler (6) intended to sample the said composite signal filtered at a predetermined frequency ($f_e$); a data processing unit (9) adapted to produce, by a frequency analysis operation, a second series of signals including the same frequency components as the said composite signal and to establish the phases and, if appropriate, the amplitudes of the signals thus produced in the receiver, by correlation with the samples (SM) obtained by the sampler (6).

7. Receiver according to claim 6, characterized in that the said processing unit (9) such as a computer or a microprocessor, belongs to a logic system adapted to ensure the co-operation and the synchronous operation of the devices constituting the acquisition and processing system and the said logic system.

8. Receiver according to one of claims 6 or 7, characterized in that an analog-to-digital converter (8; 260) is mounted between the sampler (6; 150) and the processing unit (9; 240).

9. Receiver according to one of claims 6 to 8, characterized in that an operational amplifier (7; 180), mounted as a voltage storage, is provided downstream of the sampler (6; 150).

10. Receiver according to claim 6, characterized in that said acquisition and processing system comprises a series circuit of amplifying means (30, 90, 110) and of mixing means (60, 100, 120), the amplifying means including a high frequency amplifier (30) tuned under the action of an automatic frequency-control voltage (T1) supplied by the logic system, and the mixing means being controlled by signals (F4, F6, F7) produced by the logic system.

11. Receiver according to one of claims 6 or 10, characterized in that said acquisition and processing system comprises a first series circuit of a narrow-band filter (140) and of a sampler (150) and a second series circuit of a wide-band filter (160) and of a second sampler (170), the two circuits being mounted in parallel downstream of the mixing device.

12. Receiver according to one of claims 6 to 11, characterized in that it comprises a pilot oscillator (190) of nominal frequency provided with means such as a potentiometer (220) allowing a coarse control of the central frequency and means ensuring a fine control by a control signal (F11) from the logic system, the pilot signal (F10) of the oscillator (190) being applied to the processing unit (240) of the logic system.

13. Receiver according to claim 12, characterized in that said processing unit (240) includes an internal frequency-dividing counter adapted to produce from the pilot signal (F10) an output signal (F12) allowing the production by frequency division of reference signals (F6, F1, F14, F15, F16, F17) necessary for the clocking of the filtering and acquisition operations.

14. Receiver according to one of claims 12 or 13, characterized in that the processing unit (240) is connected by a bidirectional data bus (250) to an analog-to-digital converter (260) from which it receives the signals for measuring the phases and the amplitude (SM) of the signals received by the receiver and to a circuit adapted to ensure the transfer of the programmed data of the signals received and for the production of a voltage (T2) for automatic control of the gain of the amplifying means (30) and of the signal (F11) for the control of the pilot oscillator, the circuit (270) receiving also interruption signals clocking the programme of the receiver.

15. Receiver according to claim 14, characterized in that said transfer and control circuit (270) is connected by a bus (280) to a programmable counter (290) of which it adjusts the division rate so as to create the frequency necessary for aligning the receiver successively on the various signals received.

16. Receiver according to one of claims 14 or 15, characterized in that the processing unit (240) is connected to an address coder (340) for the usual addressing of a programme storage device (300), of a data storage device (310), of a keyboard and display device (320) of a digital output device (330), of the analog-to-digital converter (260) and of the transfer and control circuit (270).

antenne 1

mélangeur  filtre  échantillonneur  amplificateur  convertisseur  A/N

-2-  -3-  -5-  -6-  -7-  -8-

dispositif
d'entree

-4-

oscillateur

$f_e$

10  11

-9-  unité  de  traitement

Fig. 1

0 128 804

FIG. 2

FIG. 3